# EUROPEAN PATENT APPLICATION

(11) **EP 2 521 159 A1**
(43) Date of publication of application: **07.11.2012**
(21) Application number: 11165152.7
(22) Date of filing: 06.05.2011
(51) Int. Cl.: H01J 37/34, H01J 37/32

(54) **Glow discharge apparatus and method with lateral rotating arc cathodes**

(71) Applicant: Pivot a.s., 78701 Sumperk (CZ)
(72) Inventor: Cselle, Tibor, 4515 Oberdorf / SO (CH); Mojmir, Jilek, 78701 Sumperk (CZ)
(74) Representative: Schmauder & Partner AG Patent- & Markenanwälte VSP

(57) **Abstract**

To improve the result of a glow discharge process is disclosed to be performed in a Physical Vapor Deposition (PVD) coating apparatus comprising a door, at least 2 lateral rotating cathodes with targets. The apparatus is equipped by rotating shields or tube shutters (4). The method comprises the steps of operating the apparatus so that the arc of said second electrode (2) burns directly to said door. The rotary shield or tube shutter on a first electrode (1) is open and said rotary shield or tube shutter (4) on a second electrode (2) is closed. Then a positive potential is applied on said first electrode (1), so that a potential between said second electrode (2) and said first electrode (1) is applied. The positive potential applied on said first electrode (1) is selected so that the electron stream does not burn only against the door since the electrons being affected by the higher potential to said first electrode (1).

## Description

### Field of invention

The invention is related to a particular glow discharge apparatus and a corresponding method, which can be used in a special Physical Vapor Deposition (PVD) coating apparatus with Lateral Rotating Arc cathodes which are known as LARC^{®}.

The cathodes should be equipped with rotating shields, as shutters.

### Background of invention

An electric glow discharge is a plasma process formed by the passage of current at 100V to several kV through a gas at low pressure, such as argon or another noble gas.

Because of a so called antenna effect the conventional glow discharge burns preferentially around sharp edges, but sometimes also inside holes. The conditions sharply depend on the pressure, substrate bias, chamber volume, loading, etc. Therefore, it is practically impossible to clean the substrate surface uniformly using conventional glow discharge. Optimization of the conventional glow discharge is difficult and sometimes even impossible.

These difficulties can be reduced by the "arc-enhanced glow discharge" method, disclosed by US 5 294 322 A and by the paper "Arc-enhanced glow discharge in vacuum machines" by J. Vetter et al. in Surface and Coating Technology No. 59 (1993), pages 152 to 155. However, the device of US 5 294 322 A needs an additional ionization anode, which must be kept clean and needs maintenance between two processes. There is also a risk of hard-arc burning on the substrates.

Additional background information according to the Lateral Rotating Arc cathodes (LARC) is disclosed in the EP 1173629 A1, EP 1 356 496 A1, EP 1 357 577 A1, EP 1 524 329 A1, und EP 1 673 488 A2.

### Description of the invention

One object of the invention is to provide an apparatus for improving the above mentioned process using a Lateral Rotating Arc cathode (LARC) cathode acting as the anode, which can be cleaned immediately after the arc enhanced glow discharge, in-situ burning behind the shutter. This object of the invention is solved by the inventive method according to claim 1. Another object of the invention is to improve the corresponding process. This object of the invention is solved by the inventive method according to claim 10. The measures of the invention have primarily the effect that - for the production of Ar⁺ ions by arc-enchanced glow discharge processes as alternative method to a conventional Ar-glow discharge process - the ions are produced by inelastic collisions of electrons generated in arc and gas atoms.

In order to generate electrons the system uses two rotary cylindrical electrodes equipped with rotary shields. One of the two cathodes is switched from negative pole of low voltage arc supply - the configuration used for the deposition of layers - to positive pole of current supply and creates therewith an ionization anode. This ionization anode in combination with the second cylindrical rotary cathode connected to a negative pole of low voltage arc supply in combination with use of the closed rotary shield, so that the second cathode is shielded from the samples, forms effective ionization supply. It is advantageous if the current supply connected to the ionization anode operates in pulse regime. It substantially improves stability of the arc-enhanced glow discharge process and eliminates formation of arc discharge on substrates.

By the higher electron current a higher ionization degree is achieved. In an arc-enhanced glow discharge process a better homogeneity of ion etching can be achieved at different positions in chamber and, therefore, the capability of etching effects for complicated substrate geometries is enhanced. The Risk of micro-arcs is decreased by use of pulsed current source as current supply to ionization anode. After the arc-enhanced glow discharge process it is very easy to remove contaminations in-situ from the cylindrical rotary electrode, which was acting as ionization anode. Contaminations caused by resputtering processes will be removed when switching the electrode from anode mode back to cathode mode, i.e. the coating deposition mode. Closing the shutter during this cathode cleaning step avoids the tools being coated.

Further advantageous details of the inventive methods are defined in the dependent claim.

The abovementioned elements and also the elements to be used according to the invention and claimed and described in the following exemplary embodiments are - beyond the explicit definitions of the claims - subject to no particular exceptions in terms of their size, shaping, use of material and their technical design, and so the selection criteria known in the respective field of use can be used in an unrestricted manner.

### Brief description of the drawings

Exemplary embodiments of the invention will be described in more detail below with reference to drawings, in which
- Figure 1: shows a schematic arrangement of the elements according to the preferred embodiment of the invention; as it is used for the arc-enhanced glow discharge process;
- Figure 2: shows a schematic arrangement of the elements according to the preferred embodiment of the invention as it is used for thin film coating step;

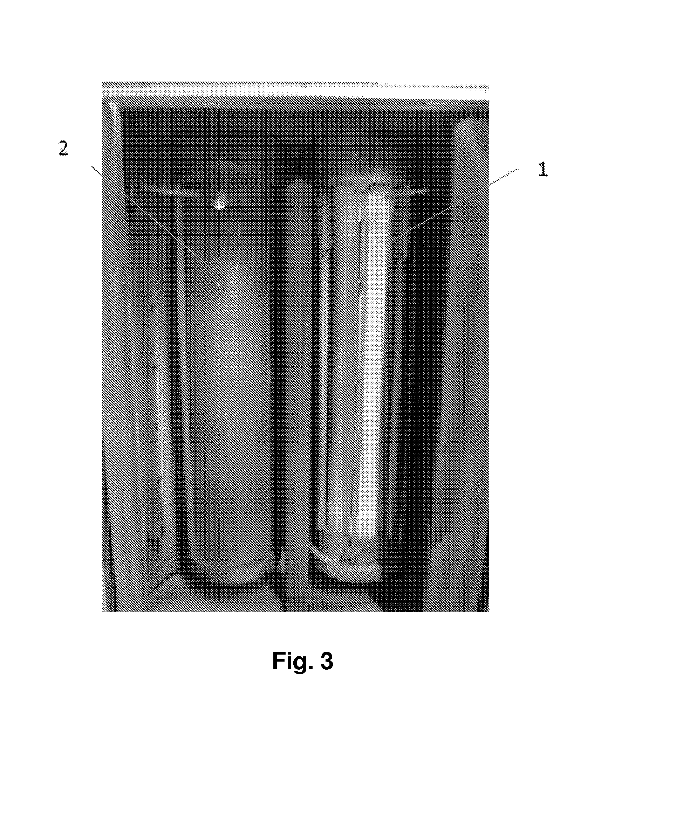

- Figure 3: shows a photographic picture of the cathode configuration according to the arrangement of figure 1;
- Figure 4: shows a comparison between different glow discharge methods, wherein 4a shows process according to the prior art and 4b shows the process according to the instant invention;
- Figure 5: Adhesion improvement of the coating and therefore tool life improvement of milling inserts with the help of the LARC Glow Discharge, with 5a a photo of the tool and 5b a quantitative diagram of the improvement;
- Figure 6: Removal of residual materials after pretreatment with glass beads blasting and therefore adhesion and tool life improvement of HSS end mills with the help of the LARC Glow Discharge, with 6a a photo of the tool and 6b a quantitative diagram of the improvement.

### Description of preferred embodiment

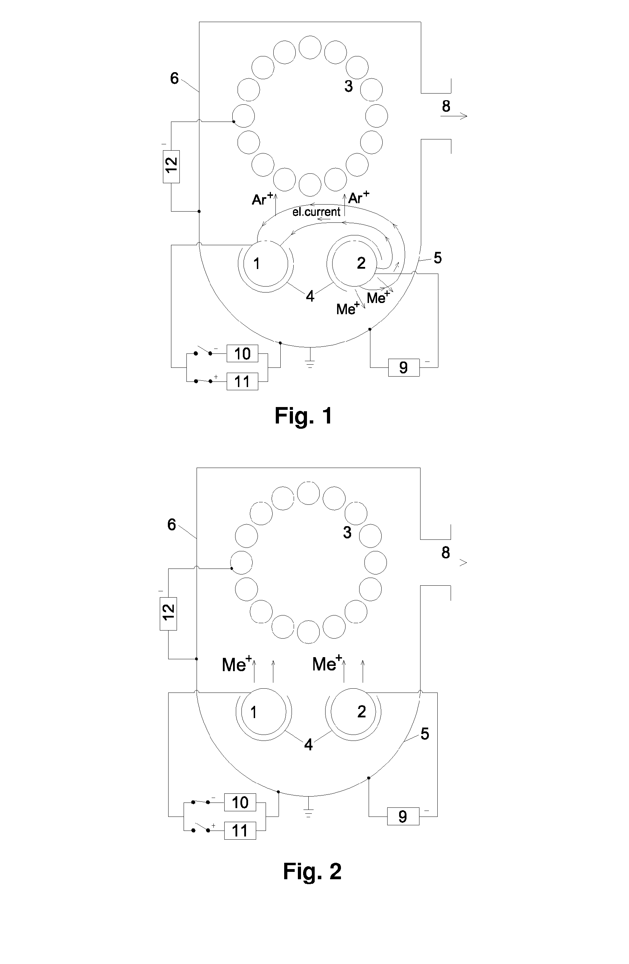

In the chamber 6 of the Physical Vapor Deposition (PVD) apparatus shown in figure 1, there are two electrodes (cathodes) 1 and 2. While the second cathode 2 is implemented by Ti - alternatively by Cr, TiAl or TiSi - target, the first electrode 1 is equipped by Aluminum target - alternatively AlSi, AlTi, AlCr. Cathode 1 is designed as an electrode which is used alternatively as anode for the LARC glow discharge process and as cathode for the coating deposition.

The cathodes are designed to have rotatable shields 4, as shutters. The shutters are rotatable steel sheets, shields between the cathode and the substrates. The aim of the shutters is avoiding pollution, contaminating the substrates while igniting the ARC of the cathode. They do avoid the evaporated target contamination being deposited onto the substrates.

The chamber is connected to a turbo pump via the outlet 8.

The cathodes (targets) 1 and 2 are supplied by the standard arc sources 9 and 10. The electrode 1 is additionally supplied by the pulse current source 11. The standard arc source 10 and the pulsed current source 11 can be switched to the electrode 1 selectively.

A bias 12 is connected between the chamber wall and the substrates 3.

In the preferred embodiment the invention is performed by the following steps: The shield on the second cathode 2 is closed. The respective arc burns directly to the door (to the back). The process is - in the described example - executed with arc current 100A and -20 V. The gas in the process according to this embodiment is Ar or combination of ArH. The rotary shield on the first electrode 1 is opened. A positive potential is applied on the first electrode 1. In the described example the positive potential is in the range of +0 to +50V. In this mode the first electrode 1 is the anode of the process. Accordingly an electrical potential of 20 to 70V is applied between the electrodes.

The electron stream does not burn only against the door because the potential against the door is only 20V. The electrons will also be attracted by the higher potential to the first electrode 1. While those attracted electrons are travelling from the second cathode 2 to electrode 1 ionize the gas in the chamber on their path. The schematic view of this process step is embodied in Fig.1. The magnetic field of the electrode 1 supports ionizing the Ar-gas. The ionization level does not depend significantly on working pressure and substrate bias as long low pressure and low substrate bias are applied, so conventional glow discharge does not burn. The low pressure, in the described process approximately 1 Pa - and the low bias, in the described process approximately 300A - ensure that the ionized Ar gas uniformly bombards the whole substrate surface. Conventional glow discharge does not burn at these conditions, since the Ar gas ionization depends on the load, the chamber volume, the tool shape etc.

When deposition step comes to place, electrode 1 is connected to low voltage arc source 10, both shutters are opened. Both electrodes 1 and 2 can be evaporated towards substrates 3 to form required coating. Schematic view of this process step is embodied in Fig.2.

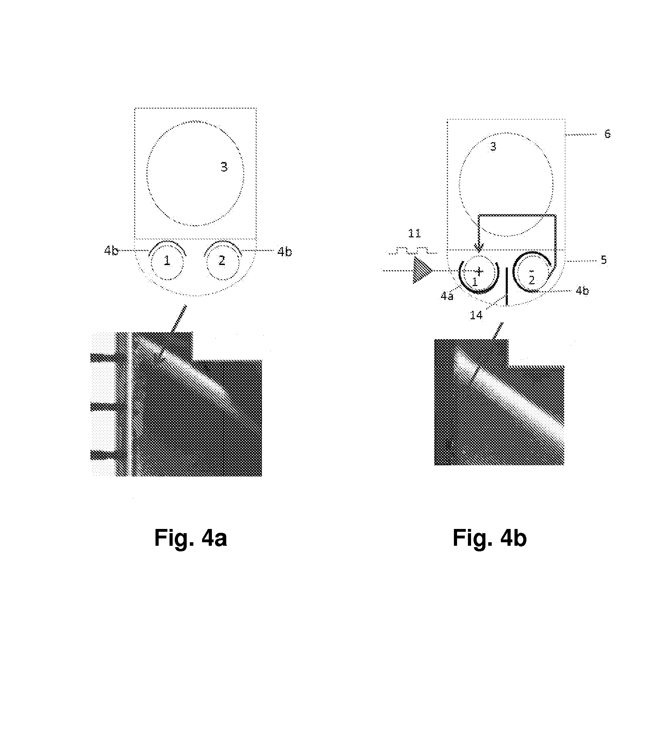

The advantage of the method according to the instant invention is demonstrated in figure 4. In figure 4a there is a conventional Ar-etching shown with metal ion etching. In figure 4b a Glow Discharge with rotating cathodes and shields is shown (U_{bias} =300V). In figure 4a the reference 1 is a anode at positive potential. In figure 4b an additional fix shutter (shield) 14 and a door 5 is shown. The photo of the state of the art result shows plaques (peeling) of approx. 0.45 mm², whereas no such peeling is present according to the embodiment of the instant invention. Figures 4a and 4b clearly demonstrate that the adhesion of the coating and the tool life of cutting tools can be improved when using the LARC Glow Discharge method according to the invention.

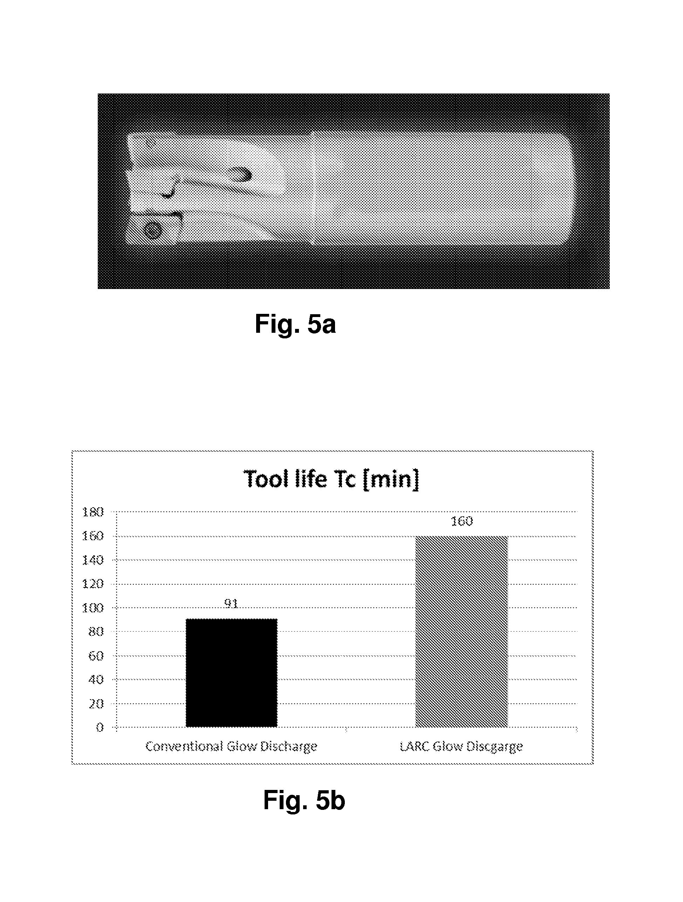

The Adhesion improvement of the coating and therefore tool life improvement of milling inserts with the help of the LARC Glow Discharge as shown in Fig. 5a and 5b (a photo of the tool and a quantitative diagram of the improvement) with the following process parameters:
Tool - insert ADMX 11T308SR
Speed - 80m/min
Work piece material -C45
Feed - 0,1mm
Depth - 8mm
ae - 22mm
Dia of the mill - 25mm
Cooling - emulsion
TiAIN + Conventional Glow Discharge - 91 min
TiAIN + LARC Glow Discharge - 160 min

If the anode is placed on the opposite side in the chamber to the ARC cathode, the anode is shadowed by the carousel and the etching efficiency is highly depending on the load of carousel.

As an important feature the LARC Glow discharge process is able to remove residual materials from the surface of the substrates, like glass sticking on the surface after glass beads blasting, diamond pastes etc., without applying any additional cleaning step (chemically or manually) as it was necessary with the conventional glow discharge.

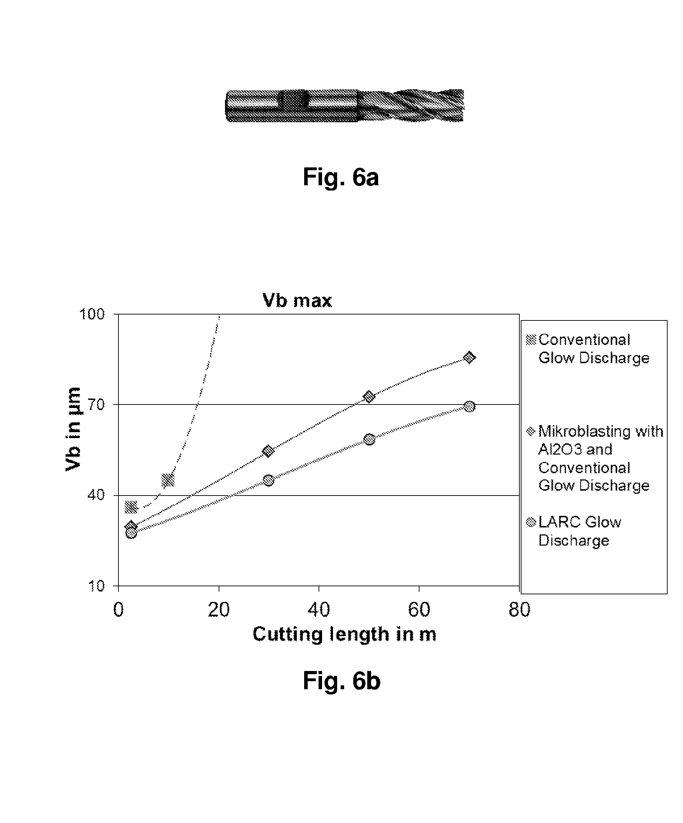

In Figure 6 the removal of residual materials after pretreatment with glass beads blastingand therefore adhesion and tool life improvement of HSS end mills with the help of the LARC Glow Discharge is shown, with 6a a photo of the tool and 6b a quantitative diagram of the improvement, with the following process parameters:

| | |
|---|---|
| Tool | Typ N 300 |
| Diameter | 16mm |
| No. of cutting etches | 4 |
| Material | 1.2312 |
| Strength | 1000 N/mm² |
| Apparatus | Deckel/Maho |
| Cutting values | vc = 100 m/min |
| | n = 1990 U/min |
| | fz = 0,08 mm |
| | vf = 636 mm/min |
| | ae = 0.2 mm |
| | ap = 24 mm |
| | Vb; Wear on the clearance |

### List of reference signs

- 1: first electrode (Al) which is used alternatively as anode for LARC glow discharge process and as cathode for the coating deposition
- 2: second cathode (Ti or Cr)
- 3: substrates
- 4: rotating shields
- 4a: open rotating shield
- 4b: closed rotating shied
- 5: door
- 6: vacuum chamber
- 8: outlet by turbo pump
- 9: low voltage arc source
- 10: low voltage arc souce
- 11: pulsed current source
- 12: bias
- 14: fixed shutter

## Claims

1. Apparatus for deposition of coatings on samples or substrates by PVD method, comprising
- a vacuum chamber of coating apparatus with inlet of reactive and inert gases;
- at least one rotating electrode (1) galvanic ally separated from the rest of the coating apparatus, connected to the positive pole of a current supply (11);
- at least one other rotating electrode (2) galvanic ally separated from the rest of the coating apparatus, wherein the negative pole of which is connected to a low voltage arc supply (9), said electrode being consumed by arc, said electrode being equipped with a rotary shield;
- a high voltage supply (12) wherein the negative pole of which is connected to the samples or substrates.

2. Apparatus according to claim 1, **characterized in that** the negative pole of the current supply (11) is connected to the vacuum chamber of the coating apparatus.

3. Apparatus according to claim 1, **characterized in that** the positive pole of the low voltage arc supply (9) is connected to the vacuum chamber of the coating apparatus.

4. Apparatus according to claim 1, **characterized in that** the positive pole of the high voltage supply (12) is connected to the vacuum chamber of the coating apparatus.

5. Apparatus according to claim 1, **characterized in that** the current supply (11) is a pulse supply.

6. Apparatus according to claims 1 to 5, **characterized in that** the rotary shield of the electrode (2) is provided to shield said electrode towards the samples or substrates during the arc burning upon it.

7. Apparatus according to claims 1 to 5, **characterized in that** the rotary shield of the other electrode (1) is provided not to shield said electrode towards the samples or substrates during the arc burning and is usable for deposition of coatings on samples or substrates.

8. Apparatus according to claims 1 to 5, **characterized in that** the electrode (1) which is connected to the positive pole of the current supply is alternatively reconnectable to a negative pole of other low voltage arc supply (10) and is usable for deposition of coatings on samples or substrates.

9. Apparatus according to claims 1 to 5, **characterized in that** the pulse current supply (11) is provided to generate the pulses with the length of 0,1 to 0,000001 s and switching frequency of 10 to 10⁶ Hz.

10. A glow discharge method in a Physical Vapor Deposition (PVD) coating apparatus according to claims 1 to 9, said method comprising the steps of
- operating the apparatus so that the arc of said second electrode (2) burns directly to said door in the virtual shutter mode, wherein said shield or tube shutters on a first electrode (1) is open and said shield or tube shutters (4) on a second electrode (2) is closed
- applying a positive potential on said first electrode (1), so that a potential between said electrode target (2) and said first electrode (1) is applied,
wherein said positive potential applied on said first electrode (1) is selected so that the electron stream does not burn against the door anymore since the electrons being effected by the higher potential to said first electrode (1).

11. The method according to claim 10, **characterized in that** said operation of the apparatus by which the arc of said second electrode burns directly to said door in the virtual shutter mode is performed with approximately -20V and 100A.

12. The method according to claim 10 or 11, **characterized in that** said positive potential applied on said first electrode (1) is approximately 1 to 50 V so that said potential between said second electrode (2) and said first electrode (1) is approximately 20 to 50 V.

13. The method according to any of the proceeding claims 10 to 12, **characterized in that** said first electrode (1) is a aluminum target, said second electrode (2) is a Titanium target and the processing gas in the apparatus is Argon.

14. The method according to any of the proceeding claims 10 to 13, **characterized in that** the rotary shield of the electrode (2) is arranged by turning to shield said electrode towards the samples or substrates during the arc burning upon it and that the rotary shield of the other electrode (1) is arranged by turning not to shield said electrode towards the samples or substrates during the arc burning, thereby deposing coatings on samples or substrates.
